# EUROPÄISCHE PATENTSCHRIFT

(11) **EP 0 443 311 B1**
(45) Veröffentlichungstag und Bekanntmachung des Hinweises auf die Patenterteilung: **20.07.1994**
(21) Anmeldenummer: 91100162.6
(22) Anmeldetag: 07.01.1991
(51) Int. Cl.: H01R 13/642, H05K 7/02

(54) **Kabelsteckverbindung zum mehrpoligen Anschluss von Kabeln an eine mit elektrischen Bauteilen bestückte Platine**
Cable connector for the multipole connection of cables to a board equipped with electrical components
Connecteur de câbles pour le raccordement multipolaire de câbles à une plaque équipée de composants électriques

(30) Priorität: 23.01.1990 DE 4001762
(43) Veröffentlichungstag der Anmeldung: 28.08.1991
(73) Patentinhaber: MAN Roland Druckmaschinen AG, 63012 Offenbach (DE)
(72) Erfinder: Schlegel, Christian, W-6072 Dreieich/Sprendlingen (DE)
(74) Vertreter: Marek, Joachim, Dipl.-Ing.

(56) Entgegenhaltungen:
- EP-A- 0 147 930
- EP-A- 0 180 674
- EP-A- 0 283 590

## Beschreibung

Die Erfindung betrifft eine Kabelsteckverbindung zum mehrpoligen Anschluß von Kabeln an eine mit elektrischen Bauteilen bestückte Platine gemäß dem Oberbegriff des ersten Patentanspruchs.

Um mit elektrischen Bauteilen bestückte Platinen mit mehrpoligen Kabeln, beispielsweise Flachbandkabeln zu verbinden, werden häufig Steckverbindungen verwendet, deren Steckerteil direkt auf der Platine sitzt und auf welches ein Buchsenteil am Kabelende steckbar ist. Häufig ist die Steckverbindung dabei als ein- bzw. zweireihige Flachsteckverbindung ausgebildet, wobei der Bestückung bzw. der Platinenschaltung entsprechend über die verschiedenen Kontakte der Steckverbindung die Übertragung einer Vielzahl analoger und/oder digitaler Signale sowie verschiedener Stromversorgungen erfolgt (beispielsweise TTL-, CMOS-Baugruppen). Den einzelnen Kontakten entsprechen somit verschiedene Spannungspegel, so daß zwischen Buchsen- und Steckerteil eine eindeutige Steckaufnahme zu erfolgen hat, da bei einem Versetzen oder Verdrehen des Buchsenteils bezüglich dem Steckerteil falsche Kontakte miteinander verbunden werden, was nicht nur zu Fehlfunktionen sondern gar zur Zerstörung der Platinenelektronik führen kann.

Um Fehlstecken in Form von Versetzen oder Verdrehen des Buchsenteils bezüglich dem Steckerteil beim Verbinden zu verhindern, kann beispielsweise, wie aus dem Stand der Elektrotechnik bekannt, der Steckerteil einen als Wanne ausgebildeten Rahmen aufweisen, in welchen ein formschlüssig dazu ausgebildeter Buchsenteil steckbar ist. Zusätzlich können an Buchsen- und Steckerteil Codiernasen/Codiernuten vorgesehen sein.

Meist müssen Platinen sehr kompakt bestückt und klein ausgeführt sein, so daß der Platz für einen Steckerteil mit Rahmen knapp wird, bzw. die Größe der Platine erheblich von den Ausmaßen des Steckerteils mitbestimmt wird. Ein Wegfall des Rahmens des Steckerteils bewirkt zwar Platzgewinn auf der Platine, bedeutet aber die Gefahr des Fehlsteckens.

Eine Möglichkeit ohne Rahmen am Steckerteil auszukommen bietet die Verwendung von doppel- oder mehrreihigen Flachsteckverbindern mit unterschiedlicher Steckerstiftzahl pro Reihe. Diese Steckerstiftanordnungen sind beispielsweise durch die Anschlußkabel im PC-Bereich bekannt.

Schutz gegen Fehlstecken bieten ferner auch Steckverbinder, insbesondere in ein- beziehungsweise doppelreihiger Flachsteck-Ausführung, bei denen in Steckerteil an einer bestimmten Stelle ein Steckerstift fehlt und an der entsprechenden Stelle im Buchsenteil kein Kontakt nebst Bohrung vorhanden ist. Bei falscher Orientierung des Buchsenteils kann dieser so nicht auf den Steckerteil gesteckt werden.

Wird bei den beiden oben beschriebenen Ausführungen von Steckverbindern trotzdem versucht den falsch zum Steckerteil orientierten Buchsenteil aufzustecken, so werden leicht ein oder mehrere Steckerstifte verbogen und der Steckerteil unbrauchbar, ohne Nacharbeit somit die ganze Platine. Diese Gefahr besteht insbesondere dann, wenn es sich um miniaturisierte Steckverbinder handelt und das Aufstecken des Buchsenteils in der Massenfertigung von Hand unter Akkordbedingungen erfolgt.

Eine Codierungseinrichtung für elektrische Kabelsteckverbindungen nach der DE-PS 3 713 262 verhindert ohne entsprechende Steckverbinder das Zustandekommen des Fehlsteckens nicht und ermöglicht lediglich durch eine elektrisch abfragbare Leitungsbrücke, ob ein Fehlstecken vorliegt oder nicht. Abgesehen davon, daß zusätzlicher Schaltungsaufwand nötig ist (Abfrage), läßt sich das Fehlstecken erst nach dem Fertigungsschritt beispielsweise in einer Kontrollstufe der Qualitätssicherung feststellen.

Der Erfindung liegt daher die Aufgabe zugrunde, eine eingangsspezifizierte Steckverbindung so weiter zu bilden, daß unter Vermeidung der im Stand der Technik angesprochenen Nachteile die Steckverbindung ohne Platzverlust auf einer kompakt auszulegenden Platine größtmögliche Sicherheit gegen Fehlstecken bietet.

Gelöst wird diese Aufgabe durch eine Steckverbindung entsprechend dem Kennzeichen des ersten Patentanspruchs. Weiterbildungen ergeben sich aus den Unteransprüchen.

Die Erfindung wird nachstehend an einem Ausführungsbeispiel näher erläutert. In der zugehörigen Zeichnung zeigt
- Figur 1: eine Steckverbindung gemäß dem Stand der Technik auf einer Platine,
- Figur 2: den auf der Platine sitzenden Steckerteil von oben gesehen,
- Figur 3: eine Steckverbindung nach Art der Erfindung ebenfalls von oben,
- Figur 4: den Schnitt A-B nach Figur 3.

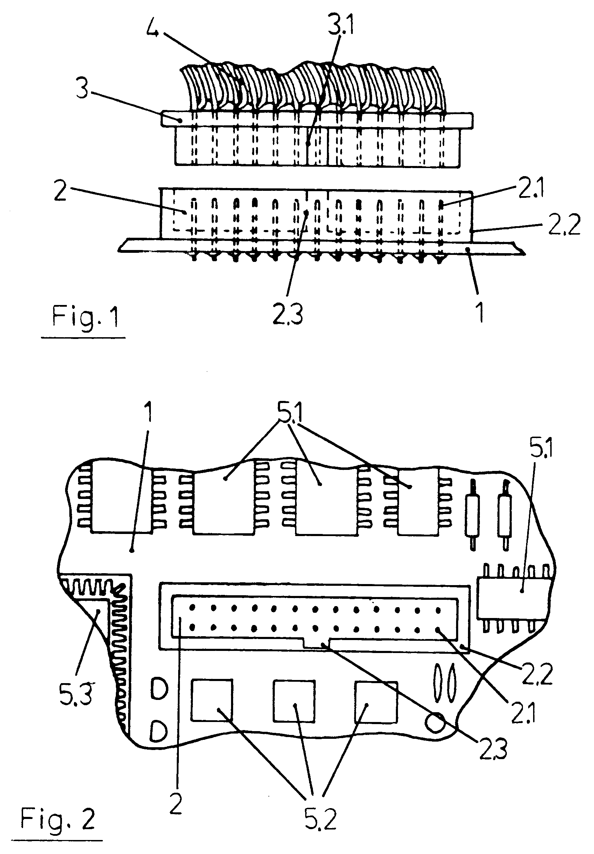

Auf einer Platine 1 ist ein Steckerteil 2, bestehend aus Steckerstiften 2.1 und einem als Wanne ausgebildeten Rahmen 2.2 angebracht. In den Rahmen 2.2 und somit auf die Steckerstifte 2.1 ist ein Buchsenteil 3 steckbar, welches an ein Mehrpolkabel 4 angeschlossen ist. Mehrpolkabel 4 ist dabei beispielsweise als Flachbandkabel ausgebildet (Figur 1). Wie angedeutet sind die Steckerstifte 2.1 direkt durch die Platine 1 geführt und auf der Unterseite von Platine 1 mit den Leiterbahnen der Schaltung verlötet.

Stecker- und Buchsenteil 2, 3 bilden wie in Figur 2 zu sehen beispielsweise eine zweireihige Flachsteckverbindung zwischen Mehrpolkabel 4 und der Platine 1. Diese ist mit elektrischen Bauteilen 5.1, 5.2, 5.3 bestückt, beispielsweise mit integrierten Festkorperschaltkreisen mit DIL-Gehäuse (Dual-In-Line-Gehäuse; 5.1), verstellbaren Kondensatoren, Wiederständen (Trimmkondensatoren, Trimmwiederstände; 5.2), Prozessoren mit Stecksockeln (5.3). Auch können elektromechanische (Relais), elektrooptische Koppler und andere Bauteiltypen auf der Platine 1 angebracht sein.

Der Rahmen 2.2 des Steckerteils 2 weist eine Nut 2.3 auf, welche zusammen mit einer Codiernase 3.1 des Buchsenteils 3 eine Codiereinrichtung gegen Verdrehen des Buchsenteils 3 bezüglich des Steckerteils 2 (Figur 1 und 2). Die Codiereinrichtung 2.3, 3.1 kann sich wie dargestellt auf der langen Seite von Buchsen- und Steckerteil 2, 3 befinden, aber auch an der kurzen.

Der auf der Platine 1 angebrachte und zum Steckerteil 2 gehörende Rahmen 2.2 benötigt Platz, vor allem, wenn er, wie er in Figur 2 nicht dargestellt zusätzlich noch mit Schrauben oder Nieten befestigt ist.

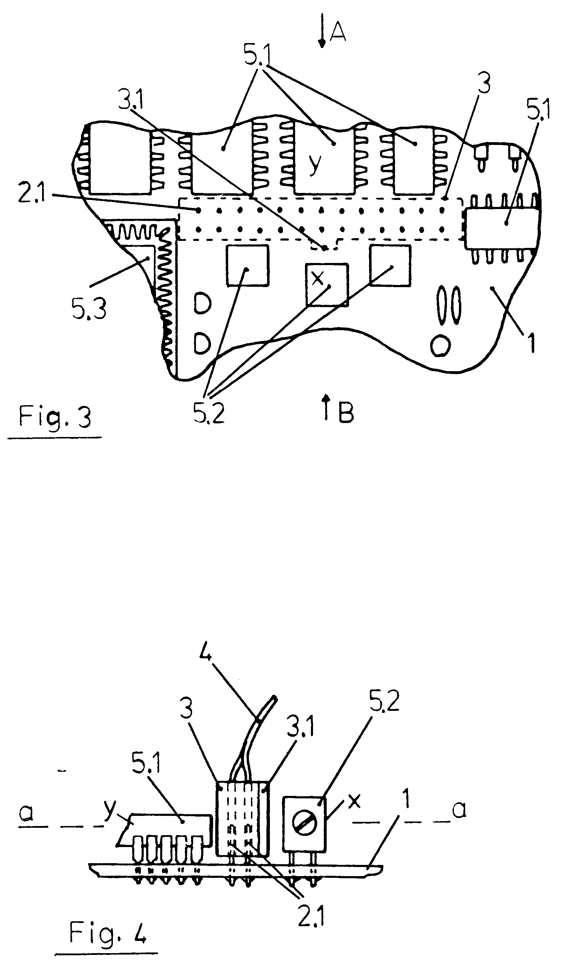

Um diesen Platz auf der Platine 1 zu sparen, d.h. die Platine 1 dichter mit Bauteilen 5.1, 5.2, 5.3 zu bestücken wurde auf den Rahmen 2.2 des Steckerteils 2 verzichtet (Figur 3). Die Bauteile 5.1, 5.2, 5.3 können nun dichter am Steckerteil 2 plaziert werden. Um trotzdem einen Schutz gegen Fehlstecken, also versetztes und/oder verdrehtes Aufstecken des Buchsenteils 3 auf die Steckerstifte 2.1 zu bieten, werden bestimmte Bauteile 5.1, 5.2, 5.3 derartig um die Außenkontur des auf den Steckerstiften 2.1 sitzenden Buchsenteils 3 angeordnet, daß die Gehäuse dieser Bauteile 5.1, 5.2, 5.3 dicht am Buchsenteil 3 anliegen. Eine Berührung muß dabei notwendigerweise nicht vorliegen.

In Figur 3 ist die Außenkontur des Buchsenteils 3 gestrichelt dargestellt, ferner ist das mit X gekennzeichnete Bauteil 5.2 derartig zum Buchsenteil 3 angeordnet, so daß die Codiernase 3.1 Platz findet. Auf der anderen Seite befindet sich ein mit Y gekennzeichnetes Bauteil 5.1, so daß ein verdrehtes Aufstecken des Buchsenteils 3 nicht möglich ist.

Bei den Bauteilen 5.1, 5.2, 5.3, welche wie oben beschrieben mit dem Buchsenteil 3 zusammen eine Codiereinrichtung bilden, handelt es sich vorteilhafterweise um solche mit mechanisch festem Sitz auf der Platine 1. Dies ist meist bei denjenigen der Fall, welche viele Anschlußkontakte besitzen (Festkörperschaltkreise mit DIL-Gehäuse; 5.1), oder bei Bauteilen 5.3 die auf speziellen Stecksockeln sitzen (beispielsweise Prozessoren). Ebenfalls geeignet sind Bauteile 5.2 mit kurzen Anschlußkontakten, besonders, wenn deren Gehäuse dicht auf der Platine liegen. Diese mechanische Standfestigkeit besitzen meist Bauelemente die beispielsweise mittels Schraubenzieher einstellbar, abgleichbar sind (Trimmpontentiometer, Trimmkondensatoren).

Die Außenabmessungen der meisten Bauteile 5.1, 5.2, 5.3 sind zwar nicht genormt (beispielsweise die DIL-Gehäuse-Größe der Festkörperschaltkreise), jedoch ist bei der Auslegung der Platine gemäß der zu realisierenden Schaltung (Layout) bekannt, welche Bauteile (Hersteller) Verwendung finden. Das Platinen-Layout (Leiterbahnen, Anschlußbohrungen) muß daher den speziellen Abmessungen der Bauteilgehäuse Rechnung tragen.

Figur 4 zeigt im Schnitt A-B gemäß Figur 3. Dieser verdeutlicht noch einmal, wie aufgrund der Anordnung der Bauteile 5.1 Y und 5.2 X ein verdrehtes, falsches Aufstecken des Buchsenteils 3 auf die Steckerstifte 2.1 durch die Codiernase 3.1 verhindert wird. Zusätzlich ist eine vorteilhafte Wahl der Länge der Steckerstifte 2.1 durch die gestrichelte Linie a angedeutet. Die Steckerstifte 2.1 stehen somit nicht höher als das flachste Bauelement, welches die beschriebene Codiereinrichtung bildet. So wird verhindert, daß der Buchsenteil 3 falsch orientiert an die Steckerstifte 2.1 herangeführt werden kann.

Die beschriebene Codiereinrichtung für eine Kabel-Platinen-Steckverbindung beschränkt sich nicht nur auf zweireihige Flachsteckverbindungen, auch ein- oder mehrreihige Steckerstiftanordnungen (Matrix-Stecker) können mit einer solchen Codiereinrichtung gegen Fehlstecken gesichert werden. Das gleiche gilt für nicht gleich beabstandete Steckerstiftanordnungen. Auch die Codiernut 3.1 an Buchsenteil 3 ist kein Muß, dann ist aber nötig, daß die Außenkontur des Buchsenteils 3 beispielsweise asymmetrisch oder versetzt zur Anordnung der Steckerstifte 2.1 verläuft. Bei entsprechender Platinenauslegung (Bauteilanordnung) können so die üblichen Buchsenteile 3 von Steckverbindern verwendet werden.

## Patentansprüche

1. Kabelsteckverbindung zum mehrpoligen Anschluß von Kabeln an eine mit elektrischen Bauteilen bestückte Platine (1), bestehend aus einem auf der Platine angebrachten Steckerteil (2) mit Steckerstiften (2.1), einem auf die Steckerstifte steckbaren Buchsenteil (3) und einer Codiereinrichtung zur Vermeidung von Fehlstecken, welche einerseits durch die Außenkontur des Buchsenteils gebildet wird,
**dadurch gekennzeichnet**,
daß die codiereinrichtung anderseits (durch um die Steckerstifte (2.1) angeordnete Bauteile (5.1, 5.2, 5.3) gebildet wird, indem deren Gehäuse an die Außenkontur des Buchsenteil (3) angrenzen.

2. Kabelsteckverbindung nach Anspruch 1,
**dadurch gekennzeichnet**,
daß die Kabelsteckverbindung als eine Flachsteckverbindung ausgebildet ist.

3. Kabelsteckverbindung nach Anspruch 2,
**dadurch gekennzeichnet**,
daß die Kabelsteckverbindung als eine mehrreihige, insbesondere als eine zweireihige Kabelsteckverbindung ausgebildet ist.

4. Kabelsteckverbindung nach einem der vorhergehenden Ansprüche,
**dadurch gekennzeichnet**,
daß Buchsenteil (3) eine Codiernase (3.1) aufweist.

5. Kabelsteckverbindung nach einem der vorhergehenden Ansprüche,
**dadurch gekennzeichnet**,
daß die Steckerstifte (2.1) voneinander gleich beabstandet auf der Platine (1) angeordnet sind.

6. Kabelsteckverbindung nach einem der vorhergehenden Ansprüche,
**dadurch gekennzeichnet**,
daß die Länge der Steckerstifte (2.1) (Linie a, Figur 4), also ihre Höhe über der Platine (1) geringer ist als das flachste, die Codiereinrichtung bildende Bauteil (5.1, 5.2, 5.3).

## Claims

1. Cable connector for multipole connection of cables to a board (1) equipped with electrical components consisting of a plug part (2) arranged on the board with plug pins (2.1), a bush part (3) which can be plugged on to the plug pins and a coding unit for avoiding mis-plugging which, on the one hand, is formed by the exterior contour of the bush part, characterised in that the coding unit on the other hand is formed by components (5.1, 5.2, 5.3) arranged around the plug pins (2.1) in that their housing border on the exterior contour of the bush part (3).

2. Cable connector according to Claim 1, characterised in that the cable plug connection is constructed as a flat connection.

3. Cable connector according to Claim 2, characterised in that the cable plug connection is constructed as a multiple row, particularly as a two-row cable connector.

4. Cable connector according to one of the preceding Claims, characterised in that bush part (3) has a coding nose (3.1).

5. Cable connector according to one of the preceding Claims, characterised in that the plug pins (2.1) are arranged evenly spaced apart from one another on the board (1).

6. Cable connector according to one of the preceding Claims, characterised in that the length of the plug pins (2.1) (line a, Figure 4), and accordingly their height above the board (1) is less than the flattest component (5.1, 5.2, 5.3) forming the coding unit.

## Revendications

1. Connexion multiple de câbles pour le raccordement multibroches de câbles à une platine (1) munie de composants électriques, constituée d'un élément de connexion (2) agencé sur la platine et comportant des broches de connexion (2.1), d'un élément à douilles (3) pouvant être enfiché sur les broches de connexion et d'un dispositif de codage pour éviter de fausses connexions, lequel est formé d'une part du contour externe de l'élément à douilles,
caractérisée en ce que le dispositif de codage est formé, d'autre part, d'éléments (5.1, 5.2, 5.3) agencés autour des broches de connexion (2.1), en ce que leurs boîtiers sont adjacents du contour externe de l'élément à douilles (3).

2. Connexion multiple de câbles selon la revendication 1,
caractérisée en ce que la connexion multiple de câbles est réalisée comme connexion multiple pour fiches plates.

3. Connexion multiple de câbles selon la revendication 2,
caractérisée en ce que la connexion multiple de câbles est réalisée comme connexion multiple de câbles à plusieurs rangées, en particulier à deux rangées.

4. Connexion multiple de câbles selon l'une des revendications précédentes,
caractérisée en ce que l'élément à douilles (3) comporte une saillie de codage (3.1).

5. Connexion multiple de câbles selon l'une des revendications précédentes,
caractérisée en ce que les broches de connexion (2.1) sont agencées sur la platine (1), en étant uniformément écartées les unes des autres.

6. Connexion multiple de câbles selon l'une des revendications précédentes,
caractérisée en ce que la longueur des broches de connexion (2.1) (ligne a figure 4), c'est-à-dire leur hauteur au-dessus de la platine (1), est plus faible que l'élément (5.1,5.2,5.3) le plus plat formant le dispositif de codage.
